Europäisches Patentamt

European Patent Office

Office européen des brevets

(11) Veröffentlichungsnummer: **0 210 610**
**A2**

## (12) EUROPÄISCHE PATENTANMELDUNG

(21) Anmeldenummer: **86110307.5**

(22) Anmeldetag: **25.07.86**

(51) Int. Cl.⁴: **H03M 1/24**

(30) Priorität: **29.07.85 DE 3527127**

(43) Veröffentlichungstag der Anmeldung:
**04.02.87 Patentblatt 87/06**

(84) Benannte Vertragsstaaten:
**CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Lippl, Friedrich, Dipl.-Ing. (FH)**
**Münchner Weg 3b**
**D-8138 Andechs(DE)**

(54) **Optische Codiereinrichtung.**

(57) Bei einem optischen Weg-oder Winkelsensor wird das durch lichtdurchlässige Abschnitte (2) einer Codescheibe (1) hindurchtretende Licht einer Parallellichtquelle (4, 5) über Kugellinsen (8) entweder direkt im Lichtwellenleiter (7) eingespeist oder auf die lichtempfindliche Fläche eines Fototransistors geleitet. Dadurch ergibt sich eine störsichere, optimale Ausnutzung des optischen Nutzsignals.

FIG 1

EP 0 210 610 A2

## Optische Codiereinrichtung

Die Erfindung betrifft eine optische Codiereinrichtung mit einer beweglichen Codescheibe, welche eine Codierung in Form von lichtdurchlässigen und lichtundurchlässigen Abschnitten trägt, mit einer an der einen Seite der Codescheibe angeordneten Parallellichtquelle, deren Licht senkrecht auf die Codescheibe auftrifft und mit einer an der anderen Seite der Codescheibe angeordneten, der Parallellichtquelle gegenüberstehenden Lichtempfängeranordnung, welche mehrere, mit den lichtdurchlässigen Abschnitten der Codescheibe bei deren Vorbeibewegung fluchtende Lichtempfangsflächen aufweist.

Je nachdem, ob die Codescheibe eine geradlinige Bewegung oder eine Drehbewegung ausführt, handelt es sich bei einer derartigen Codiereinrichtung um einen Wegsensor oder um einen Winkelsensor, wobei jedoch die Funktionsweise der Lichtabtastung in beiden Fällen gleich ist. Da die lichtdurchlässigen Abschnitte der Codescheibe verhältnismäßig große Flächen in der Größenordnung von etwa 3 mm im Durchmesser aufweisen und diese Flächen aus fertigungstechnischen und optischen Gründen nicht wesentlich verringert werden können, wurden bisher auf der Empfängerseite relativ großflächige Fotodioden verwendet, um das auftreffende Licht möglichst gut auszunutzen. Das Ausgangssignal dieser Fotodioden wurde dann elektronisch verstärkt und weitergeleitet. Sollte bei derartigen Sensoren die Informationsübertragung über Lichtwellenleiter vorgenommen werden, so wurde das verstärkte Ausgangssignal wiederum über einen elektrooptischen Wandler in einen Lichtwellenleiter eingespeist.

Daneben wurde auch bereits vorgeschlagen, die durch die Codescheibe hindurchtretenden Lichtsignale unmittelbar in Lichtwellenleiter einzuspeisen, wobei wegen der erwähnten Größe der Lichtdurchtrittsfläche Kunststoff-Lichtwellenleiter mit großem Querschnitt verwendet wurden, die jedoch aufgrund von Dämpfung und Alterung Nachteile bei den Übertragungseigenschaften aufweisen.

Aufgabe der Erfindung ist es, eine optische Codiereinrichtung der eingangs genannten Art zu - schaffen, bei der eine verbesserte Ausnutzung des durch die Codescheibe hindurchtretenden Lichts und ein vereinfachter Empfang bzw. eine vereinfachte Übertragung ermöglicht wird.

Erfindungsgemäß wird diese Aufgabe dadurch gelöst, daß die Lichtempfangsflächen jeweils kleiner sind als die lichtdurchlässigen Abschnitte der Codescheibe und daß vor jeder Lichtempfangsfläche eine Kugellinse angeordnet ist.

Bei der erfindungsgemäßen Codiereinrichtung wird also das durch die Codescheibe hindurchtretende Licht jeweils zunächst auf eine Kugellinse geleitet und durch diese im wesentlichen auf einen Punkt fokussiert. Die Lichtempfangsfläche kann dadurch also wesentlich geringer sein als die Durchtrittsfläche der Codescheibe. Je nach Art der Auswertung kann an der Lichtempfangsfläche die lichtempfindliche Fläche eines Fototransistors bzw. eines vergleichbaren Fotoelements angeordnet sein. Besonders vorteilhaft ist jedoch die Erfindung anzuwenden, wenn das Licht der Codescheibe unmittelbar über die Kugellinse in eine Lichtleitfaser eingekoppelt wird. Das modulierte Nutzsignal kann dann entfernt vom Sensor und von möglichen Störquellen ausgewertet werden, so daß der optische Weg-bzw. Winkelsensor am Einsatzort störsicher angeordnet werden kann. Denn auch eine aufwendige optisch-elektrisch-optische Wandlung im Sensor mit einer aufwendigen und störanfälligen Elektronik ist nicht erforderlich. Die entsprechend dem verwendeten Code verwendeten Abtastelemente, beispielsweise sechs, können in Form der Kugellinsen und der nachgeordneten Lichtempfangsflächen jeweils in einem gemeinsamen Aufnahmeblock vereinigt, beispielsweise in Kunststoff eingeklebt, eingeklemmt oder vergossen sein. Insbesondere können die das Licht aufnehmenden Lichtwellenleiter in Kunststoff eingebettet werden.

Die Erfindung wird nachfolgend an Ausführungsbeispielen anhand der Zeichnung näher erläutert. Es zeigt

Fig. 1 die schematische Anordnung eines optischen Weg-oder Winkelsensors mit Lichtwellenleitern am Ausgang,

Fig. 2 eine schematische Darstellung der Lichteinkopplung in einen Lichtleiter über eine Kugellinse,

Fig. 3 die Lichteinkopplung über eine Kugellinse zu einem Fototransistor,

Fig. 4 verschiedene Befestigungsanordnungen für Kugellinsen und Lichtwellenleiter in einem Aufnahmeblock.

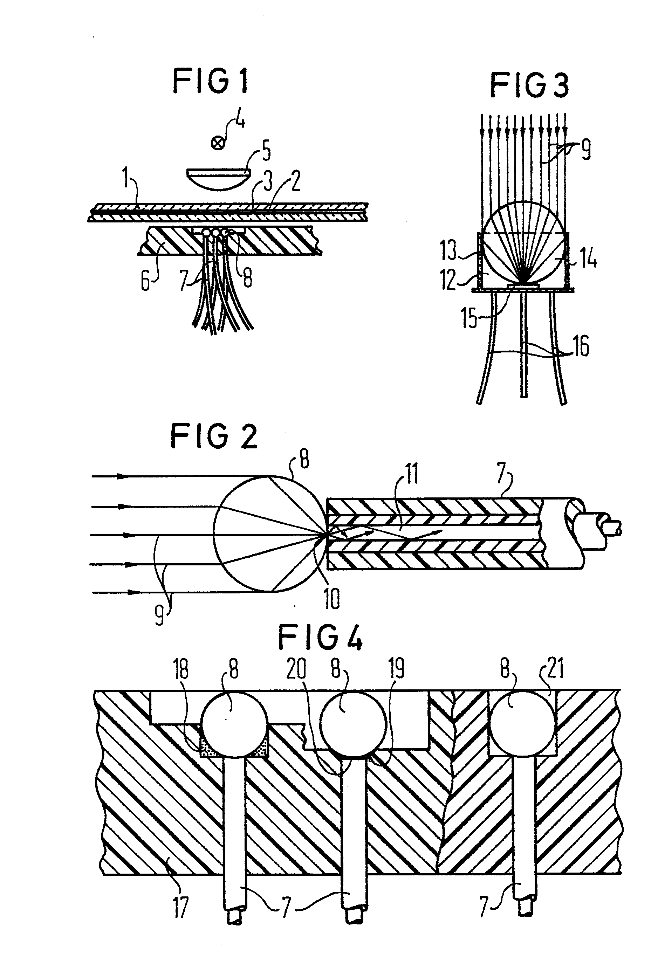

Fig. 1 zeigt schematisch eine Codescheibe 1, die einen Winkel-oder Wegcode in Form von lichtdurchlässigen Stellen 2 und lichtundurchlässigen Stellen 3 trägt. Die Codescheibe wird entweder in Drehbewegung oder in Längsbewegung an einer Abtaststelle vorbeigeführt. An dieser Abtaststelle ist an der einen Seite der Codescheibe 1 eine Lichtquelle 4 mit einer Kondensorlinse 5 angeordnet, durch die paralleles Licht durch die Codescheibe bzw. deren lichtdurchlässige Stellen 2 gesandt wird. Gegenüber von der Parallellichtquelle 4, 5 ist eine Empfangsanordnung 6 vorgesehen, wobei jede Spur der Codescheibe über einen Lichtwellenleiter 7 mit vorgeschalteter Kugellinse 8 abgetastet wird.

Die Einkopplung des Lichts in die Lichtwellenleiter 7 ist in Fig. 2 vergrößert dargestellt. Die von der Lichtquelle 4 bzw. der Kondensorlinse 5 kommenden parallelen Lichtstrahlen 9 werden durch die Kugellinse 8, die aus einem Material mit entsprechenden Brechungsindex besteht, auf den der Einfallseite gegenüberliegenden Punkt 10 an der Kugeloberfläche fokussiert. Dieser Punkt 10 ist auf den Kern 11 des Lichtwellenleiters 7 justiert, so daß nahezu der gesamte Lichtstrom, der auf die Kugel 8 auftrifft, in dem Kern 11 des Lichtwellenleiters eingekoppelt wird. Dieses Licht kann als Analogsignal direkt übertragen und ausgewertet werden, ohne daß durch eine optisch-elektrisch-optische Wandlung Störsignale auftreten können.

In Fig. 3 ist eine weitere Möglichkeit gezeigt. Dort ist ein Fototransistor 12 gezeigt, in dessen Gehäuse 13 eine Kugellinse 14 angeordnet ist und das auftreffende Parallellicht 9 auf die verhältnismäßig kleine lichtempfindliche Fläche 15 des Fototransistors fokussiert. Das Signal wird in diesem Fall über die Leitungen 16 abgegriffen. Auch eine derartige Anordnung von Fig. 3 könnte also bei einem Codierer gemäß Fig. 1 eingesetzt werden, um das optische Nutzsignal möglichst gut auszunutzen. Allerdings wird in diesem Fall die Möglichkeit einer direkten optischen Weiterleitung des Nutzsignals nicht verwendet.

Fig. 4 zeigt eine mögliche Gestaltung der Empfängeranordnung mit einem Aufnahmeblock 17 aus Kunststoff, wobei die Lichtwellenleiter 7 entweder in entsprechende Bohrungen eingesteckt oder bei der Herstellung des Aufnahmeblocks 17 eingebettet werden. Fig. 4 zeigt dabei verschiedene Möglichkeiten der Befestigung für die jeweilige Kugellinse 8. Diese kann beispielsweise in eine Aufnahmebohrung 18 eingesetzt und durch Ausfüllen der Hohlräume verklebt werden. Daneben ist eine Anordnung gezeigt, wobei die Kugellinse 8 in eine Vertiefung 19 eingesetzt und über eine Klebefläche 20 mit dem Lichtwellenleiter 7 verbunden ist. In der rechten Anordnung in Fig. 4 ist die Kugellinse 8 in eine entsprechend angepaßte Aufnahmebohrung 21 eingepreßt.

Bezugszeichenliste

1. Codescheibe
2. lichtdurchlässige Stelle
3. lichtundurchlässige Stelle
4. Lichtquelle
5. Kondensorlinse
6. Empfangsanordnung
7. Lichtwellenleiter
8. Kugellinse
9. Lichtstrahl
10. Brennpunkt
11. Kern
12. Fototransistor
13. Gehäuse
14. Kugellinse
15. lichtempfindliche Fläche
16. Leitung
17. Aufnahmeblock
18. Aufnahmebohrung
19. Vertiefung
20. Klebefläche
21. Aufnahmebohrung

## Ansprüche

1. Optische Codiereinrichtung mit einer beweglichen Codescheibe, welche eine Codierung in Form von lichtdurchlässigen und lichtundurchlässigen Abschnitten trägt, mit einer an der einen Seite der Codescheibe angeordneten Parallellichtquelle, deren Licht senkrecht auf die Codescheibe auftrifft und mit einer an der anderen Seite der Codescheibe angeordneten, der Parallellichtquelle gegenüberstehenden Lichtempfängeranordnung, welche mehrere, mit den lichtdurchlässigen Abschnitten der Codescheibe bei deren Vorbeibewegung fluchtende Lichtempfangsflächen aufweist, **dadurch gekennzeichnet**, daß die Lichtempfangsflächen (10; 15) jeweils kleiner sind als die lichtdurchlässigen Abschnitte (2) der Codescheibe und daß vor jeder Lichtempfangsfläche eine Kugellinse (8; 14) angeordnet ist.

2. Codiereinrichtung nach Anspruch 1, **dadurch gekennzeichnet**, daß die Lichtempfangsflächen jeweils die lichtempfindlichen Flächen (15) von Fotoelementen, wie Fototransistoren, sind.

3. Codiereinrichtung nach Anspruch 1, **dadurch gekennzeichnet**, daß die Lichtempfangsflächen jeweils die Einkoppelflächen (10) eines Lichtwellenleiters (7) sind.

4. Codiereinrichtung nach einem der Ansprüche 1 bis 3, **dadurch gekennzeichnet**, daß die Kugellinsen (8) in einem gemeinsamen Aufnahmeblock (17) angeordnet und befestigt sind.

5. Codiereinrichtung nach Anspruch 3 und 4, **dadurch gekennzeichnet**, daß die zu den Kugellinsen (8) gehörigen Lichtwellenleiter (7) in dem Aufnahmeblock (17) mit vergossen sind.

FIG 1

FIG 3

FIG 2

FIG 4